# EUROPEAN PATENT SPECIFICATION

(11) **EP 4 521 722 B1**
(45) Date of publication and mention of the grant of the patent: **12.08.2026**
(21) Application number: 23812094.3
(22) Date of filing: 22.05.2023
(51) Int. Cl.: H04M 1/02, H05K 5/00, G06F 1/16

(54) **ELECTRONIC DEVICE COMPRISING FASTENING STRUCTURE AND METHOD FOR MANUFACTURING SAME**
ELEKTRONISCHE VORRICHTUNG MIT BEFESTIGUNGSSTRUKTUR UND VERFAHREN ZUR HERSTELLUNG DAVON
DISPOSITIF ÉLECTRONIQUE COMPRENANT UNE STRUCTURE DE FIXATION ET SON PROCÉDÉ DE FABRICATION

(30) Priority: 24.05.2022 KR 20220063558; 15.06.2022 KR 20220072963
(43) Date of publication of application: 12.03.2025
(73) Proprietor: Samsung Electronics Co., Ltd., Suwon-si, Gyeonggi-do 16677 (KR)
(72) Inventor: LEE, Jonghun, Suwon-si Gyeonggi-do 16677 (KR); NAM, Yunjin, Suwon-si Gyeonggi-do 16677 (KR); YOON, Kwondeuk, Suwon-si Gyeonggi-do 16677 (KR); CHOI, Hyunsuk, Suwon-si Gyeonggi-do 16677 (KR)
(74) Representative: Appleyard Lees IP LLP
(86) International application number: PCT/KR2023/006923
(87) International publication number: WO 2023/229320

(56) References cited:
- JP-A- 2008 103 505
- JP-A- 2008 300 635
- JP-A- 2009 129 576
- KR-A- 20220 064 139
- US-A1- 2016 276 757

## Description

### [Technical Field]

Various embodiments of the disclosure relate to an electronic device including a fastening structure and a method for manufacturing same.

### [Background Art]

Remarkable developments in information communication, semiconductor technologies, and the like have enabled the rapid spread and use of various electronic devices. Specifically, electronic devices have been recently developed to perform communication while being carried.

The electronic device may refer to a device performing a particular function according to its equipped program, such as a home appliance, an electronic scheduler, a portable multimedia player, a mobile communication terminal, a tablet PC, a video/sound device, a desktop PC or laptop computer, or a navigation for automobile. For example, such electronic devices may output stored information in the form of sound or image. In line with the high degree of integration of electronic devices and the widespread use of super-fast large-capacity wireless communication, it has recently become possible to equip a single electronic device, such as example, mobile communication terminal, with various functions. For example, not only a communication function, but also an entertainment function such as gaming, a multimedia function such as music/video playback, communication and security functions for mobile banking and the like, and/or functions such as a scheduling function and an electronic wallet function may be integrated into a single electronic device. KR20220064139 describes an electronic device comprising a housing.

### [Detailed Description of the Invention]

### [Technical Problem]

A housing included in an electronic device may be coupled to another component inside the electronic device or another housing. With respect to the coupling of the housing with another component, the stability of the coupling is related to various factors such as the thickness of the coupled parts, material, or manufacturing method.

An aspect of the present disclosure is to reduce manufacturing costs by processing a portion of a housing and secure thickness (stiffness) of a portion to be coupled to another component.

It should be understood, however, that the present invention is not limited to the above-described embodiments, but may be variously modified without departing from the scope of the invention.

### [Technical Solution]

According to the present invention, an electronic device according to claim 1 includes a first housing including a first surface and a second surface opposite the first surface, a second housing that covers at least a portion of the second surface of the first housing, a printed circuit board disposed between the first housing and the second housing, and a display disposed on the first surface of the first housing and electrically connected to the printed circuit board, wherein the first housing includes a first member forming an outer edge of the first housing, a second member disposed inside the outer edge formed by the first member and configured to provide the second surface of the first housing for having the printed circuit board disposed thereon, a mold member configured to couple the first member and the second member and having at least a portion thereof overlapping the first member and the second member, and a fastening hole formed to be connected to the second housing through a fastening member, the second member includes a fastening area which is disposed inside the mold member and formed by hemming at least a portion of the fastening area extend in a direction that the second surface faces, and the fastening hole is formed through at least a portion of the fastening area of the second member disposed inside the mold member. Exemplary embodiments are set out in claims 2 to 11.

According to the present invention, a method for manufacturing a housing of an electronic device, according to claim 12 includes a process of forming a first member which is exposed to the outside of the electronic device and disposed along an edge of the electronic device, a process of disposing a second member inside the first member, a process of forming a fastening area on the second member, wherein the second member includes a wing area obtained by cutting at least portion of the second member, and at least a portion of the wing area is folded to form the fastening area extending in a direction perpendicular to a side of the second member, a process of injecting a mold member to couple the first member and the second member, wherein the mold member is injected to allow the fastening area to be disposed inside the mold member, and a process of forming a fastening hole to pass through at least a portion of the fastening area. Exemplary embodiments are set out in claims 13 to 15.

### [Advantageous Effects]

According to various embodiments, by allowing a portion of a housing to include a fastening structure processed through a press hemming method, an electronic device having reduced manufacturing costs and increased coupling strength may be provided.

### [Brief Description of Drawings]

FIG. 1 is a block view illustrating an electronic device in a network environment according to various embodiments.
FIG. 2 is a front perspective view of an electronic device according to various embodiments of the disclosure.
FIG. 3 is a rear perspective view of an electronic device according to various embodiments of the disclosure.
FIG. 4 is an exploded perspective view of an electronic device according to various embodiments of the disclosure.
FIGS. 5A, 5B, 5C, and 5D are diagrams schematically illustrating a manufacturing procedure of a first support member according to various embodiments.
FIG. 6 is a view illustrating a fastening structure provided on a first support member according to various embodiments.
FIGS. 7A, 7B, 7C, and 7D are diagrams illustrating a manufacturing procedure of a fastening area according to various embodiments.
FIG. 8 is a sectional view of the fastening area of FIGS. 7A, 7B, 7C, and 7D.
FIGS. 9A, 9B, 9C, and 9D are diagrams illustrating a manufacturing procedure of a fastening area according to another embodiment.
FIG. 10 is a sectional view of the fastening area of FIGS. 9A, 9B, 9C, and 9D.
FIG. 11 is a view illustrating additional processing having been performed on the fastening area of FIG. 10.
FIGS. 12A, 12B, 12C, and 12D are diagrams illustrating a manufacturing procedure of a fastening area according to still another embodiment.
FIG. 13 is a sectional view of the fastening area of FIGS. 12A, 12B, 12C, and 12D.
FIGS. 14A, 14B, 14C, and 14D are diagrams illustrating a manufacturing procedure of a fastening area according to still another embodiment.
FIG. 15 is a sectional view of the fastening area of FIGS. 14A, 14B, 14C, and 14D.
FIG. 16 is a view illustrating a manufacturing procedure of a fastening area according to still another embodiment.
FIG. 17 is a sectional view of the fastening area of FIG. 16.
FIG. 18 is a view illustrating an arrangement relationship of a first support member and a second support member according to various embodiments.
FIG. 19 is a flowchart illustrating a method for manufacturing a fastening structure according to various embodiments.

### [Mode for Carrying out the Invention]

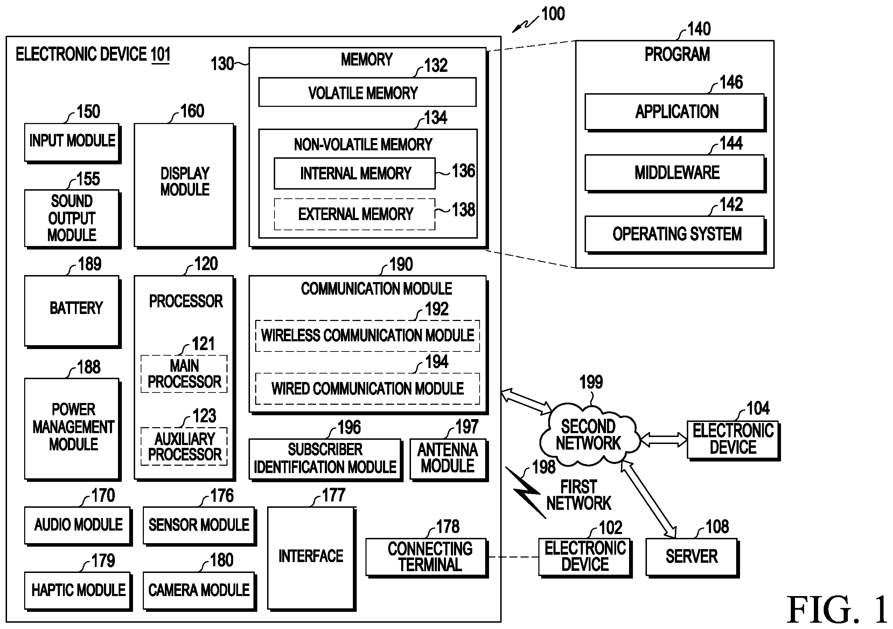

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. **In** another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

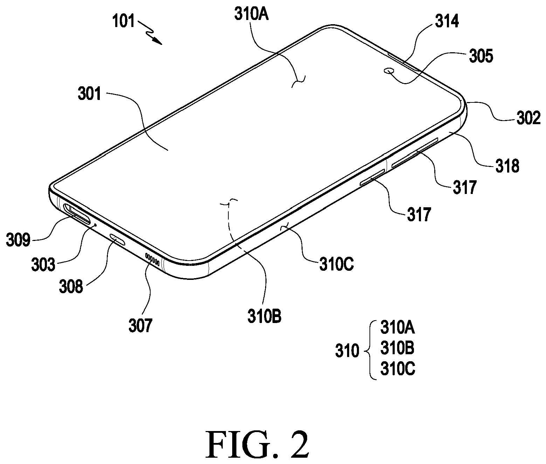

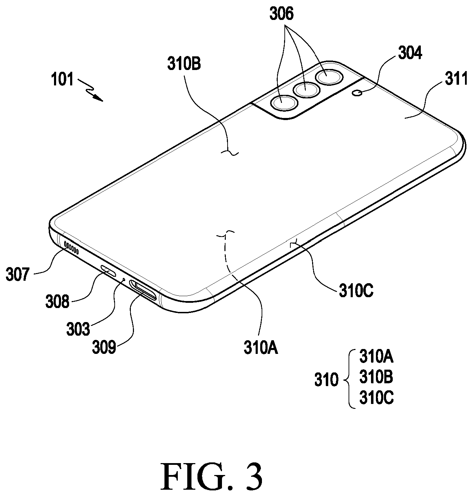

FIG. 2 is a front perspective view of an electronic device 101 according to various embodiments of the disclosure. FIG. 3 is a rear perspective view of an electronic device 101 according to various embodiments of the disclosure.

Referring to FIGS. 2 and 3, the electronic device 101 according to an embodiment may include a housing 310 including a front surface 310A, a rear surface 310B, and a lateral surface 310C surrounding a space between the front surface 310A and the rear surface 310B. According to another embodiment (not shown), the housing 310 may refer to a structure for forming a portion of the front surface 310A in FIG. 2, and the rear surface 310B and the lateral surface 310C in FIG. 3. According to an embodiment, at least a portion of the front surface 310A may be formed by a substantially transparent front plate 302 (e.g., a glass plate including various coating layers or polymer plate). The rear surface 310B may be formed by a rear plate 311. The rear plate 311 may include, for example, glass, ceramic, polymers, metals (e.g., aluminum, stainless steel (STS), or magnesium), or a combination of at least two thereof. The lateral surface 310C may be coupled to the front plate 302 and the rear plate 311 and formed by a lateral bezel structure (or a "lateral member") 318 including a metal and/or polymer. In an embodiment, the rear plate 311 and the lateral bezel structure 318 may be integrally formed and include the same material (e.g., glass, a metal material such as aluminum, or ceramic). According to another embodiment, the front surface 310A and/or the front plate 302 may include a portion of a display 301.

According to an embodiment, the electronic device 101 may include at least one of a display 301, an audio module 303, 307, or 314 (e.g., audio module 170 of FIG. 1), a sensor module (e.g., sensor module 176 of FIG. 1), a camera module 305 or 306 (e.g., camera module 180 of FIG. 1), a key input device 317 (e.g., input module 150 of FIG. 1), and a connector hole 308 or 309 (e.g., connection terminal 178 of FIG. 1). In an embodiment, the electronic device 101 may omit at least one of the components (e.g., the connector hole 309) or additionally include another component. According to an embodiment, the display 301 may be visually exposed through, for example, a substantial portion of the front plate 302.

According to an embodiment, the surface (or the front plate 302) of the housing 310 may include a screen display area formed by visually exposing the display 301. By way of example, the screen display area may include the front surface 310A.

According to another embodiment (not shown), the electronic device 101 may include a recess or an opening formed on a portion of the screen display area (e.g., the front surface 310A) of the display 301, and include at least one of the audio module 314, the sensor module (not shown), a light-emitting element (not shown), and the camera module 305, which is aligned with the recess or the opening. In another embodiment (not shown), the display 301 may include at least one of the audio module 314, the sensor module (not shown), the camera module 305, a fingerprint sensor (not shown), and the light-emitting element (not shown) on the back surface of the screen display area.

According to another embodiment (not shown), the display 301 may be combined to or disposed adjacent to a touch sensing circuit, a pressure sensor for measuring a strength (pressure) of a touch, and/or a digitizer for detecting a magnetic field-type stylus pen.

According to an embodiment, at least a portion of the key input device 317 may be disposed on the lateral bezel structure 318.

According to an embodiment, the audio module 303, 307, or 314 may include, for example, a microphone hole 303 and a speaker hole 307 or 314. A microphone for obtaining a sound from outside may be disposed in the microphone hole 303 and in another embodiment, multiple microphones may be arranged to detect a direction of a sound. The speaker hole 307 or 314 may include an outer speaker hole 307 and a receiver hole 314 used for calling. In an embodiment, the speaker hole 307 or 314 and the microphone hole 303 may be implemented into one hole and a speaker may be included without a speaker hole 307 or 314 (e.g., a piezo speaker).

According to an embodiment, a sensor module (not shown) may generate an electrical signal or a data value corresponding to, for example, an internal operation state or external environment state of the electronic device 101. The sensor module (not shown) may include a first sensor module (not shown) (e.g., a proximity sensor) disposed on the front surface 310A of the housing 310 and/or a second sensor module (not shown) (e.g., a fingerprint sensor). The sensor module (not shown) may include a third sensor module (not shown) (e.g., an HRM sensor) disposed on the rear surface 310B of the housing 310 and/or a fourth sensor module (not shown) (e.g., a fingerprint sensor). According to another embodiment (not shown), the fingerprint sensor may be disposed at the rear surface 310B as well as at the front surface 310A (e.g., the display 301) of the housing 310. The electronic device 101 may further include at least one sensor module not shown in the drawings, for example, a gesture sensor, a gyro sensor, an air pressure sensor, a magnetic sensor, an acceleration sensor, a grip sensor, a color sensor, an infrared (IR) sensor, a biometric sensor, a temperature sensor, humidity sensor, or an illuminance sensor (not shown).

According to an embodiment, the camera module 305 or 306 may include a front camera module 305 disposed at the front surface 310A of the electronic device 101 and a rear camera module 306 and/or a flash 304 disposed on the rear surface 310B. The camera module 305 or 306 may include one or more of lenses, an image sensor, and/or an image signal processor. The flash 304 may include, for example, a light emitting diode or a xenon lamp. According to an embodiment, two or more lenses (infrared camera, wide-angle, and telephoto lens) and image sensors may be arranged on one surface of the electronic device 101.

According to an embodiment, the key input device 317 may be disposed on the lateral surface 310C of the housing 310. According to another embodiment, the electronic device 101 may not include a portion or the entirety of the key input device 317 described above, and the excluded key input device 317 may be implemented as various forms such as a soft key on the display 301.

According to an embodiment, the light emitting element (not shown) may be disposed on, for example, the front surface 310A of the housing 310. The light emitting element (not shown) may provide state information of the electronic device 101 in a form of light, for example. According to another embodiment, the light emitting element (not shown) may provide, for example, a light source interlocking with an operation of the front camera module 305. The light emitting element (not shown) may include, for example, an LED, an IR LED, and/or a xenon lamp.

According to an embodiment, the connector hole 308 and 309 may include, for example, a first connector hole 308 capable of receiving a connector (e.g., a USB connector) for transmitting or receiving power and/or data to or from an external electronic device or a connector (e.g., an earphone jack) for transmitting or receiving an audio signal to or from an external electronic device, and/or a second connector hole 309 capable of receiving a storage device (e.g., a subscriber identification module (SIM) card). According to an embodiment, the first connector hole 308 and/or the second connector hole 309 may be omitted.

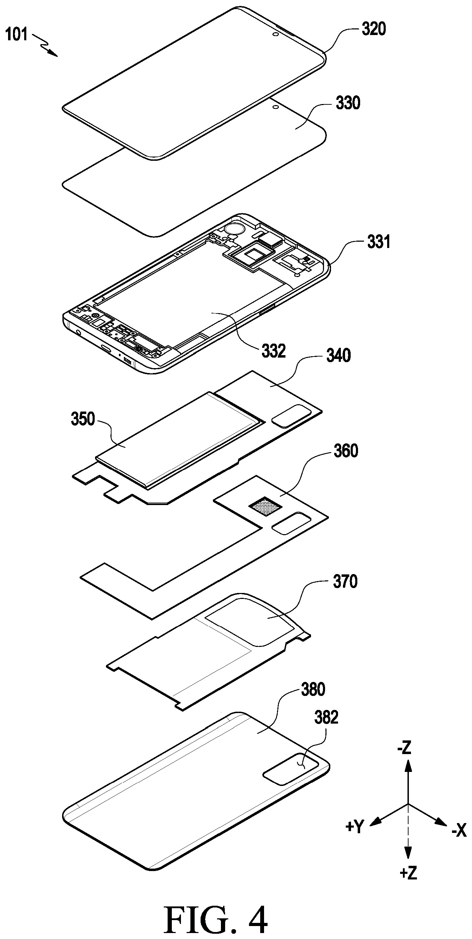

FIG. 4 is an exploded perspective view of an electronic device according to various embodiments of the disclosure.

Referring to FIG. 4, the electronic device 101 (e.g., the electronic device 101 in FIG. 2 and FIG. 3) may include at least one from among a front plate 320 (e.g., the front plate 302 in FIG. 2), a display 330 (e.g., the display 301 in FIG. 2), a first support member 332 (e.g., a bracket), a printed circuit board 340, a battery 350, a second support member 360 (e.g., a rear case), an antenna 370, and a rear plate 380. In an embodiment, the electronic device 101 may omit at least one of the components (e.g., the first support member 332 or the second support member 360) or additionally include another component. At least one of the components of the electronic device 101 may be the same as or similar to at least one of the components of the electronic device 101 in FIG. 2 or FIG. 3, and thus the overlapping description thereof will be omitted.

According to an embodiment, the first support member 332 may be disposed in the electronic device 101 to be connected to the lateral bezel structure 331 or integrally formed with the lateral bezel structure 331. The first support member 332 may be formed of, for example, a metal material and/or a non-metal (e.g., a polymer) material. The first support member 332 may have the display 330 coupled to one surface thereof and the printed circuit board 340 coupled to the other surface thereof. A processor, a memory, and/or an interface may be mounted on the printed circuit board 340. The processor may include, for example, one or more of a central processing device, an application processor, a graphic process device, an image signal processor, a sensor hub processor, or a communication processor. According to an embodiment, the memory may include, for example, a volatile memory or a nonvolatile memory. According to an embodiment, the interface may include, for example, a high definition multimedia interface (HDMI), a universal serial bus (USB) interface, an SD card interface, and/or an audio interface. The interface, for example, may electrically or physically connect the electronic device 101 to an external electronic device, and may include a USB connector, an SD card/MMC connector, or an audio connector. According to an embodiment, the battery 350 (e.g., the battery 189 in FIG. 1) is a device for supplying power to at least one component (e.g., the camera module 312) of the electronic device 101, and may include, for example, a non-rechargeable primary battery, a rechargeable secondary battery, or a fuel cell. At least a portion of the battery 350 may be disposed on, for example, a substantially identical plane to the printed circuit board 340. The battery 350 may be disposed and integrally formed in the electronic device 101 or may be disposed to be attachable to/detachable from the electronic device 101.

According to an embodiment, the second support member 360 (e.g., the rear case) may be disposed between the printed circuit board 340 and the antenna 370. For example, the second support member 360 may include one surface to which at least one of the printed circuit board 340 or the battery 350 is coupled and the other surface to which the antenna 370 is coupled.

According to an embodiment, the antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may wirelessly transmit and receive power required for charging or perform near field communication with an external device, for example. For example, the antenna 370 may include a coil for wireless charging. In another embodiment, an antenna structure may be formed by a portion or a combination of the lateral bezel structure 331 and/or the first support member 332.

According to various embodiments, an electronic device 101 may include a camera module (e.g., the camera module 306 of FIG. 3) disposed in the housing (e.g., the housing 310 in FIG. 2). According to an embodiment, the camera module 306 may be disposed on the first support member 332 and may be a rear camera module (e.g., the camera module 312 in FIG. 3) capable of obtaining an image of a subject located on a rear side (e.g., +Z direction) of the electronic device 101. According to an embodiment, at least a portion of the camera module 312 may be exposed outside the electronic device 101 through the opening 382 formed through the rear plate 380.

The electronic device 101 disclosed in FIGS. 2 to 4 has a bar type or a plate-type exterior, but the disclosure is not limited thereto. For example, the electronic device illustrated herein may be a rollable electronic device or a foldable electronic device. The "rollable electronic device" may refer to an electronic device in which a display (e.g., the display 330 in FIG. 3) is bendable and transformable so that at least a portion thereof can be wound or rolled to be received in a housing (e.g., the housing 310 in FIG. 2). According to user needs, a screen display area of the rollable electronic device may be expanded to be used by unfolding the display or exposing more area of the display to the outside. The "foldable electronic device" may refer to an electronic device in which different two areas of the display may be folded in a direction to face each other or in a direction to face opposite directions from each other. Generally, in a mobile state, the different two areas of the display of the foldable electronic device are folded in a direction to face each other or in a direction to face away from each other, and in an actual use state, a user may unfold the display to make the two different areas form a substantially flat plate shape. In an embodiment, the electronic device 101 according to various embodiments disclosed herein may include various electronic devices such as a laptop computer or a camera as well as a mobile electronic device such as a smartphone.

According to an embodiment, the electronic device 101 may include a fastening structure formed to connect the first support member 331 and other components (e.g., the second support member 360). The fastening structure may be provided on at least a portion of the first support member 331. In a description below, the fastening structure provided on the first support member 331 will be described with reference to the drawings.

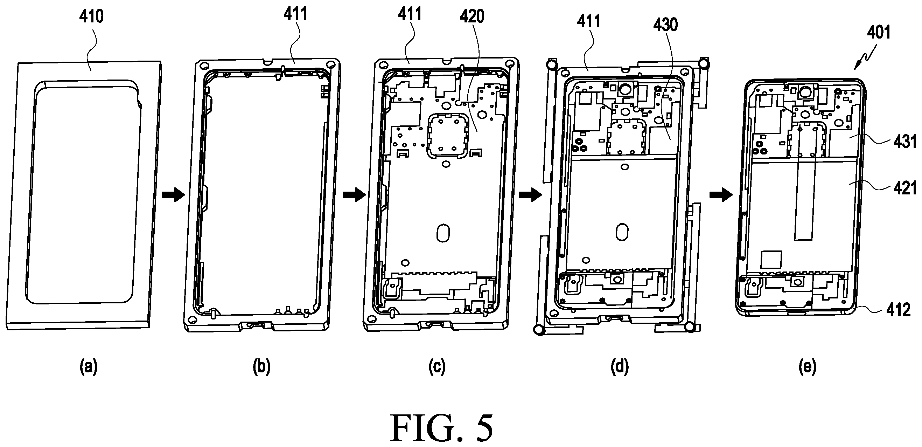

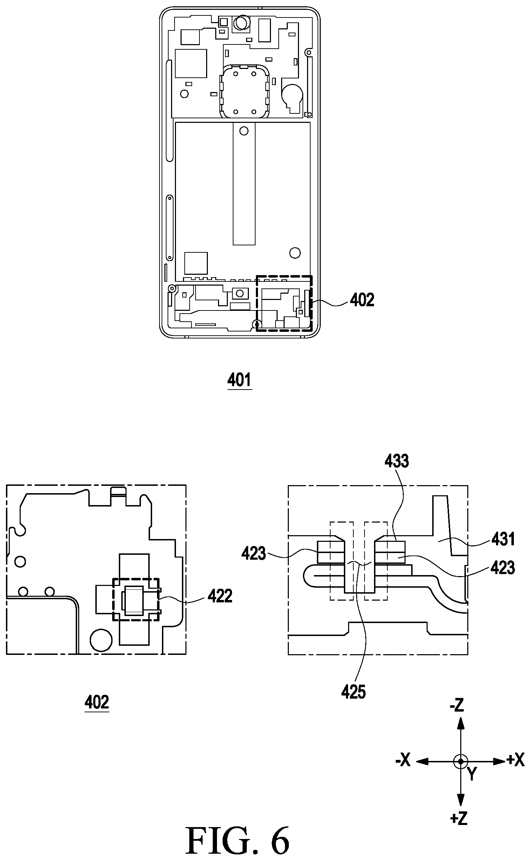

FIGS. 5A to 5D are diagrams schematically illustrating a manufacturing procedure of a first support member according to various embodiments. FIG. 6 is a view illustrating a fastening structure provided on a first support member according to various embodiments.

Referring to FIGS. 5A to 6, the first support member 401 may include all or some of a first member 411, a second member 420, and a mold member 430. The description of the first support member (e.g., the first support member 331 in FIG. 4) in the embodiments described above may be applied to the first member 401 in FIGS. 5A to 6.

According to various embodiments, the first member 411 may be manufactured by processing a raw material 410. In an embodiment, the raw material 410 may form the first member 411 through CNC processing. In an embodiment, the first member 411 may provide an exterior for the first support member 400. For example, the first member 411 may have an edge shape and provide an exterior of an edge portion of the first support member 400. In some embodiments, the raw material 410 may include a metal. However, without limitation thereto, the raw material 410 or the first member 411 may include polymer.

According to various embodiments, the second member 420 may be disposed inside the first member 411. The second member 420 may correspond to a plate formed through a press method or CNC processing. In an embodiment, the second member 420 may include a metal, but without limitation thereto, may include a polymer material.

According to various embodiments, the first member 411 and the second member 420 may be coupled to each other through the mold member 430. In an embodiment, in a state in which the second member 420 is disposed in the first member 411, the mold member 430 may be formed through insert injection.

In a state in which the first member 411, the second member 420, and the mold member 430 are coupled to each other, CNC processing may be performed to complete the first support member 400. Various components of the electronic device 101 may be arranged on the completed first support member 401 as described above.

According to various embodiments (referring to FIG. 6), the first support member 401 may include a fastening structure 402. The fastening structure 402 may be provided as a combination of the second member 420 and the mold member 430.

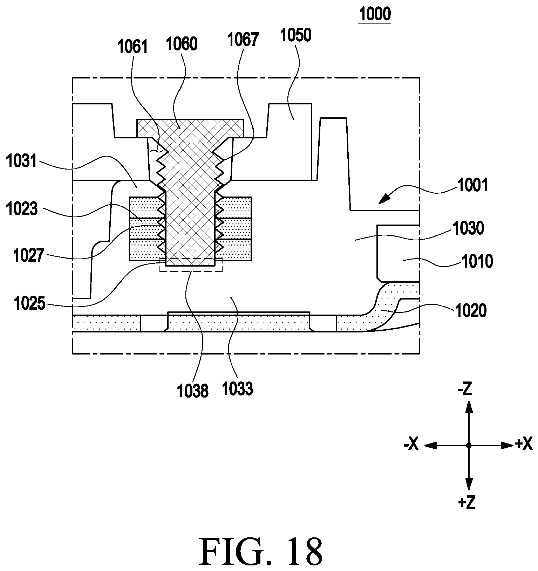

According to various embodiments, the second member 420 may include a fastening area 422. In an embodiment, the fastening area 422 may be referred to as an area to which a fastening member (e.g., the fastening member 1060 in FIG. 18) is inserted to connect the first support member 401 to other components (e.g., the second support member 360).

In an embodiment, at least a portion of the second member 420 may be hemmed to define the fastening area 422. In some embodiments, an additional welding process or a bonding process may be performed on at least a portion of the hemming-processed second member 420. Accordingly, the bonding or stiffness of a partial area of the hemming-processed second member 420 may be improved. For example, as a partial area of the second member 420 is hemmed, the fastening area 422 may extend in a direction perpendicular to a surface of the second member 420. An area in which the second member 420 is hemmed may be referred to as a hemmed area 423.

In an embodiment, after the hemmed area 423 is defined, the first member 411 and the second member 420 may be coupled to each other through the mold member 430. The injection of the mold member 430 may allow the first member 411 and the second member 420 to be connected to each other and the mold member 430 to be disposed to surround the hemmed area 423.

In an embodiment, after the mold member 430 is disposed, a fastening hole 425 may be formed on the hemmed area 423. The fastening hole 425 may be formed on the fastening area 422 covered with the mold member 430 through a CNC tapping process.

In an embodiment, the hemmed area 423 around the fastening hole 425 may be covered by the mold member 430. For example, the mold member 433 may be disposed on an upper side (the -z-axis direction) and a lower side (the +z-axis direction) of the hemmed area 423. In addition, the mold member 431 may be disposed on a lateral side (the x-axis direction) of the hemmed area 423 to surround the hemmed area 423.

In various embodiments, the hemmed area 423 is formed by hemming at least a portion of the second member 420 (the fastening area 422) to provide a height enough to allow the fastening member (e.g., the fastening member 1060 in FIG. 18) to be inserted. In addition, the fastening hole 425 is formed in a state in which the hemmed area 423 is disposed and inserted into the mold member 430, causing the stiffness of the hemmed area 423 to be improved.

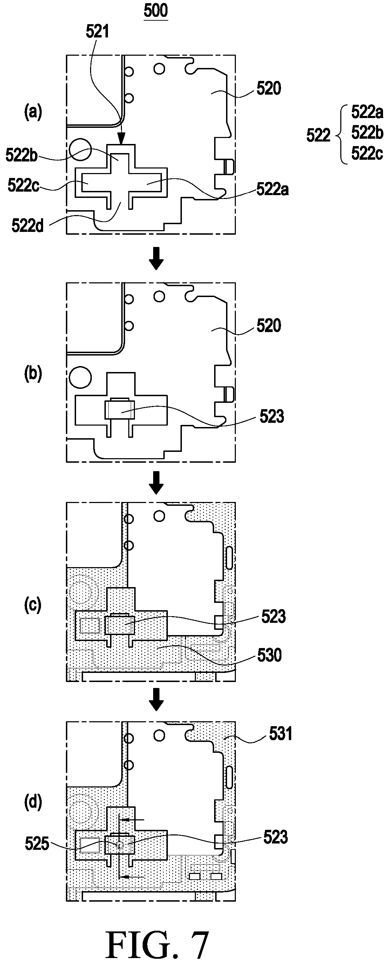

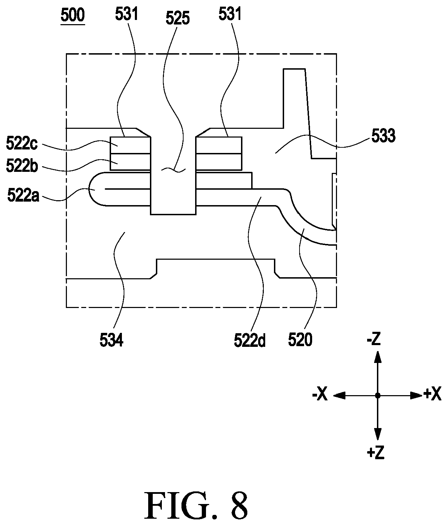

FIGS. 7A to 7D are a view illustrating a manufacturing procedure of a fastening area according to various embodiments. FIG. 8 is a sectional view of the fastening area of FIGS. 7A to 7D.

Referring to FIGS. 7A to 8, the fastening area 522 may include multiple wing areas 522a, 522b, and 522c. The description of the second member 410 and the mold member 430 in the described embodiments may be applied to a second member 520 and a mold member 530 in FIGS. 7A to 8.

According to various embodiments, the fastening area 522 may include a first wing area 522a, a second wing area 522b, and a third wing area 522c forming a cross shape. The first wing area 522a, the second wing area 522b, and the third wing area 522c may be hemmed so that at least partial areas thereof overlap each other and may provide a hemmed area 523. In an embodiment, the hemmed area 523 may be connected to other areas of the second member 520 through a connection area 522d.

According to various embodiments (referring to part (a) of FIGS. 7A to 7D), at least a portion of the second member 520 is processed to form the fastening area 522. For example, a portion of the second member 520 may be cut to form the fastening area 522 including the multiple wing areas 522a,522b, and 522c.

According to various embodiments (referring to parts (c) and (d) of FIGS. 7A to 7D), after the multiple wing areas 522a,522b, and 522c are hemmed, the mold member 530 may be injected to surround the hemmed area 523. After the mold member 530 is injected, a fastening hole 525 may be formed to pass through at least a portion of the mold member 530 and at least a portion of the hemmed area 523. As described above, the fastening hole 525 may be formed through a CNC tapping process.

According to various embodiments (referring to FIG. 8), the first wing area 522a, the second wing area 522b, and the third wing area 522c may be hemmed to at least partially overlap each other. In an embodiment, the first wing area 522a, the second wing area 522b, and the third wing area 522c are hemmed to overlap each other so that the hemmed area 523 may extend from a surface of the second member 520 in a vertical direction (e.g., the -z-axis direction).

According to various embodiments, the mold member 530 may include a first area 531 covering an upper side (e.g., the -z-axis direction) of the hemmed area 523, a second area 534 covering a lower side (e.g., the +z-axis direction), and a third area 533 covering the hemmed area 523 to surround a gap between the first area 531 and the second area 534. In other words, except for a portion of the hemmed area 523 in which the fastening hole 525 is formed, the hemmed area 523 may be expressed to be disposed inside the mold member 530. However, without limitation thereto, in some embodiments, the mold member (e.g., 531) covering the upper side (the -z-axis direction) of the hemmed area 523 may be removed and the upper side (the -z-axis direction) of the hemmed area 523 may be exposed to the outside of the mold member.

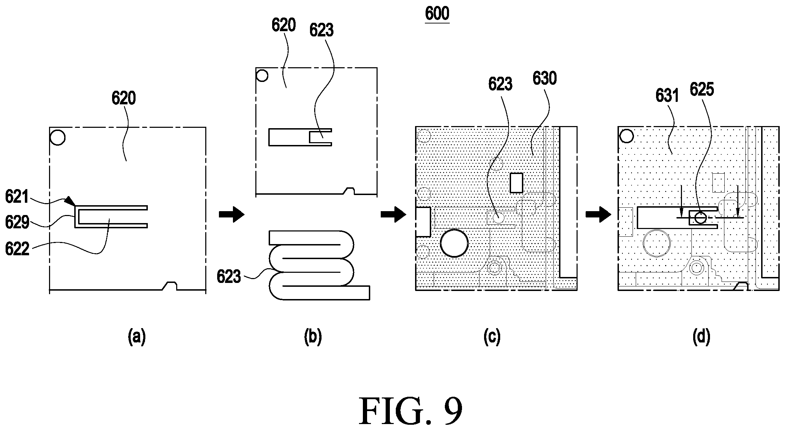

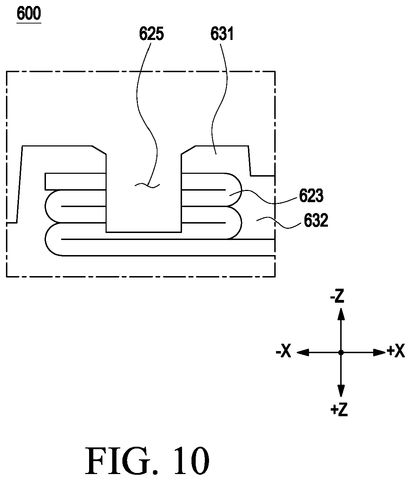

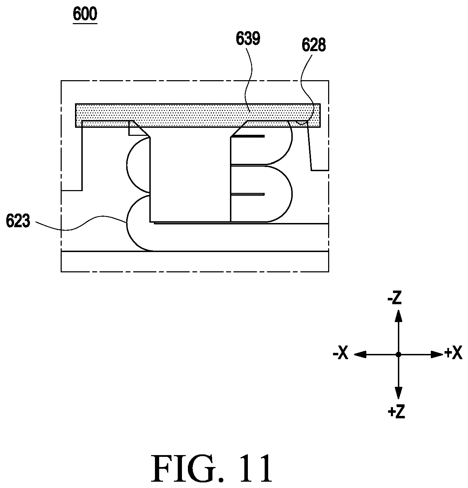

FIGS. 9A to 9D are a view illustrating a manufacturing procedure of a fastening area according to another embodiment. FIG. 10 is a sectional view of the fastening area of FIGS. 9A to 9D. FIG. 11 is a view illustrating additional processing having been performed on the fastening area of FIG. 10.

Referring to FIGS. 9A to 11, the fastening structure 600 may include a second member 620 on which the fastening area 621 including one wing area 622 is formed. The description of the second member 420 or 520 and the mold member 430 or 530 in the described embodiments may be applied to the second member 620 and a mold member 630 in FIGS. 8 to 9D.

According to various embodiments, the wing area 622 may be formed by cutting a portion of the second member 620. For example, a cut area 629 corresponding to a portion of the second member 620 surrounding the wing area 622 may be formed through the second member 620.

According to various embodiments, the wing area 622 may be hemmed multiple times. For example, the wing area 622 is hemmed multiple times so that the hemmed area 623 extending in the vertical direction (e.g., the -z-axis direction) may be formed.

According to various embodiments, the mold member 630 may be disposed to surround the hemmed area 623. The mold member 630 may include a portion of an exterior processed (e.g., CNC processing) to be a processed mold member 631. As described above, the fastening hole 625 may be formed to pass through both the processed mold member 631 and the hemmed area 623. In some embodiments, before additional exterior processing is performed on the mold member 630, the fastening hole 625 may be formed first.

According to various embodiments, similarly as described above, the mold member 630 may be disposed around the hemmed area 623. For example, the mold member 631 or 632 may be disposed on each of an upper side of the hemmed area 623 and a lateral side of the hemmed area 623.

In some embodiments, different from what is described above, the hemmed area 623 may be formed by hemming the wing area 622 in one direction. For example, the hemmed area 623 may be formed by rolling the wing area 622 in a circular shape or by rolling a hemmed portion at an angle.

According to various embodiments (referring to FIGS. 9A to 10), an upper area 639 of the hemmed area 623 may be processed. For example, the mole member (631 in FIGS. 9A to 9D) disposed on the upper side (the -z-axis direction) of the hemmed area 623 may be processed and removed. As the mold member (631 in FIGS. 9A to 9D) covering the upper side of the hemmed area 623 is removed, the upper side 628 of the hemmed area 623 may be exposed to the outside of the mold member 630. The upper side 628 of the hemmed area 623 exposed to the outside may be provided as a ground. The embodiments shown in FIGS. 9A to 11 may be applied to all fastening structure described above and below in the disclosure.

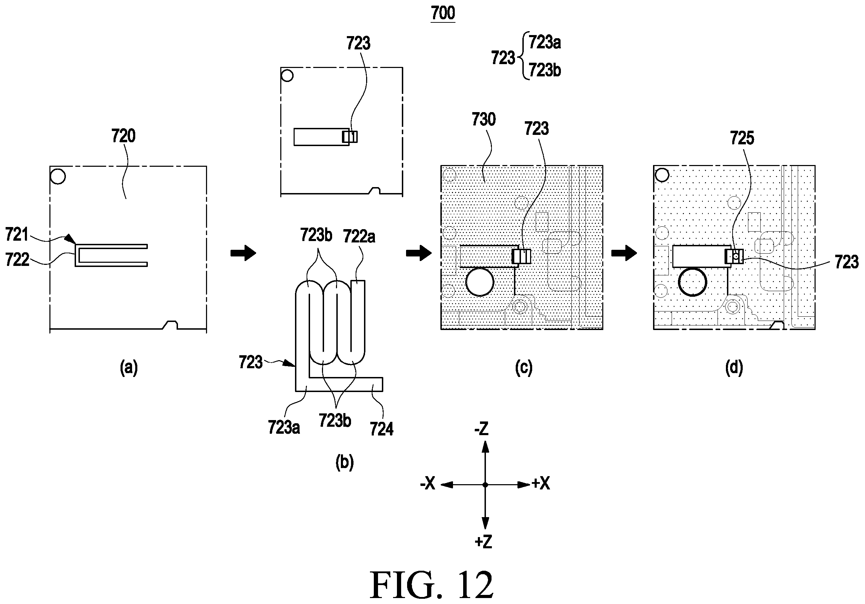

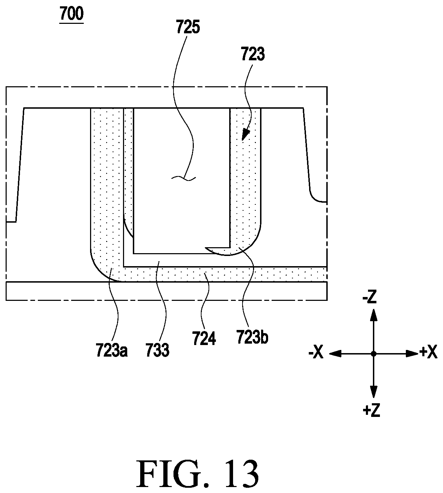

FIGS. 12A to 12D are a view illustrating a manufacturing procedure of a fastening area according to still another embodiment. FIG. 13 is a sectional view of the fastening area of FIGS. 12A to 12D.

Referring to FIGS. 12A to 13, the fastening structure 700 may include a hemmed area 723 hemmed in the vertical direction. The description of the second member 420,520, or 620 and the mold member 430,530, or 630 in the described embodiments may be applied to a second member 720 and a mold member 730 in FIGS. 11 to 12D.

According to various embodiments, the second member 720 may include a fastening area 721 including one wing area 722. The description of the cut area 629 shown in FIGS. 9A to 9D may be applied to a description of the cut area 729.

According to various embodiments, the wing area 722 may be hemmed to face the vertical direction (the -z-axis direction). In an embodiment, the wing area 722 may include a first hemmed area 723a having a portion practically hemmed at 90 degrees. The wing area 722a extending from the first hemmed area 723a may be hemmed to extend in a horizontal direction (e.g., the x-axis direction). In other words, second hemmed areas 723b hemmed in the extended wing area 722a may be disposed to face the vertical direction (the z-axis direction). In various embodiments, the hemmed area 723 may be disposed in the mold member 730 and a fastening hole 725 may be formed. Since this is similar to what was described above, redundant explanation will be omitted.

According to various embodiments, an upper area 726 of hemmed area 723 may be exposed to the outside of the mold member 730. However, this is merely an example, and the mold member 730 may be disposed to surround all of the hemmed area 723.

According to various embodiments, the mold member 733 may be disposed, based on the first hemmed area 723a, between a partial area 724 of the second member 720 extending toward one side of the first hemmed area 723a and a partial area (e.g., the second hemmed area 723b) of the second member 720 extending toward the other side of the first hemmed area 723a. As such, even if the hemmed area 723 is hemmed in the vertical direction, at least a portion (e.g., 733) of the mold member 730 may support the hemmed area 723 in the vertical direction (the z-axis direction) so as to secure the stiffness of the fastening structure 700.

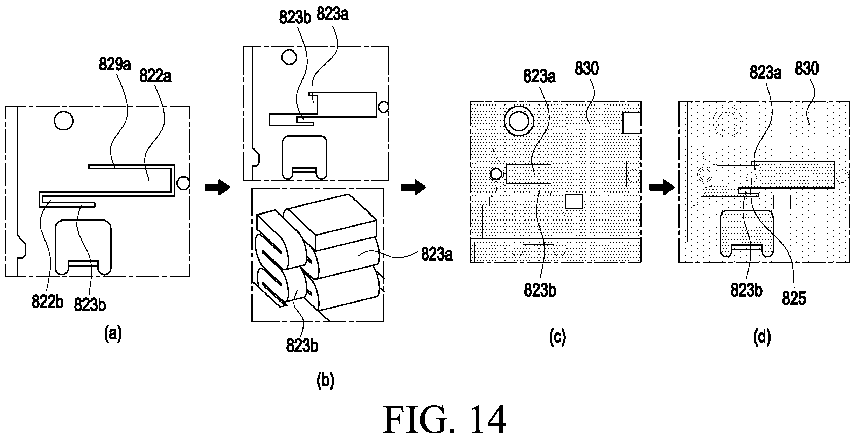

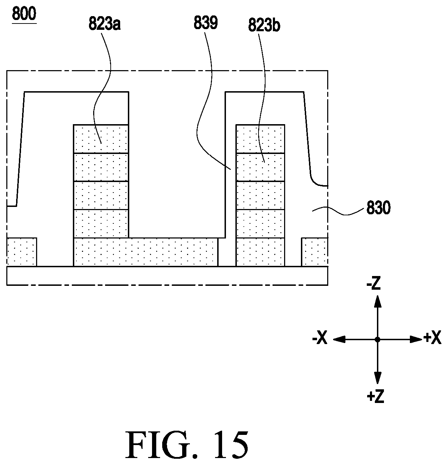

FIGS. 14A to 14D are a view illustrating a manufacturing procedure of a fastening area according to still another embodiment. FIG. 15 is a sectional view of the fastening area of FIGS. 14A to 14D.

Referring to FIGS. 14A to 15, the fastening structure 800 may include a first wing area 822b and a second wing area 822b hemmed in opposite directions. The description of the second member 420,520,620, or 720 and the mold member 430,530,630, or 730 in the described embodiments may be applied to a second member 820 and a mold member 830 in FIGS. 14A to 15.

According to various embodiments, the second member 820 may include a first wing area 822a and a second wing area 822b. In an embodiment, the first wing area 822a and the second wing area 822b may be hemmed in opposite directions. In an embodiment, the first wing area 822a and the second wing area 822b may have different sizes but without limitation thereto, may be formed to have an identical size.

According to various embodiments, the first wing area 822a and the second wing area 822b may be formed through one cut area 829. For example, the cut area 829 may continue as one line and a portion of the second member 820 formed through a portion of the cut area 829 may be provided as the first wing area 822a and another portion of the second member 820 formed through another portion of the cut area 829 may be provided as the second wing area 822b. In an embodiment, the portion of the cut area 829 forming the first wing area 822a may be provided as a first cut area 829a and the portion of the cut area 829 forming the second wing area 822b may be provided as a second cut area 829b.

According to various embodiments, a hemmed area 823 may include a first hemmed area 823a formed by hemming the first wing area 822a and a second hemmed area 823b formed by hemming the second wing area 822b. The first hemmed area 823a and the second hemmed area 823b may be arranged to be adjacent to each other.

According to various embodiments, a fastening hole 825 may be formed by cutting the entirety or a portion of the first hemmed area 823a and/or the second hemmed area 823b. In an embodiment, the fastening hole 825 may be formed by removing a partial area of the first hemmed area 823a. The second hemmed area 823b disposed adjacent to the fastening hole 825 may be disposed inside the mold member 830. The second hemmed area 823b may support the mold member 839 disposed adjacent to the second hemmed area 823b and improve the stiffness thereof. The mold member may not be disposed on a partial area 825a of the first hemmed area 823a surrounding the fastening hole 825. However, this is merely an example, and the fastening hole 825 may be formed through all of the first hemmed area 823a and the second hemmed area 823b.

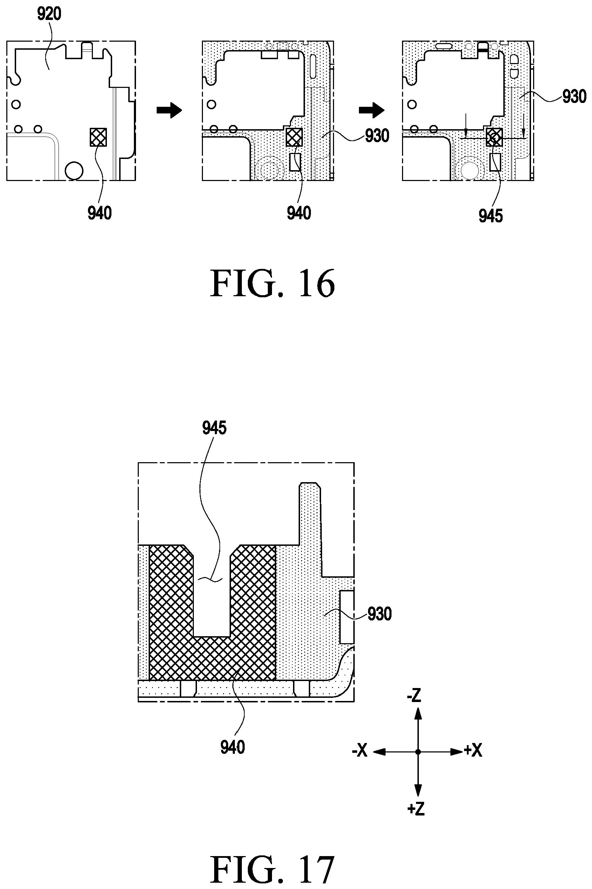

FIG. 16 is a view illustrating a manufacturing procedure of a fastening area according to still another embodiment. FIG. 17 is a sectional view of the fastening area of FIG. 16.

Referring to FIGS. 16 and 17, the fastening member 900 may include a second member 920, an auxiliary member 940, and a mold member 930. The description of the fastening structure 500, 600, 700, and 800 in the embodiments described above may be applied in whole or in part to the fastening structure 900 in FIGS. 15 and 16.

According to various embodiments, the auxiliary member 940 may be disposed on the second member 920. For example, the auxiliary member 940 may be coupled to the second member 920 through welding. In an embodiment, in a state in which the auxiliary member 940 is disposed on the second member 920, the mold member 930 may be injected. The auxiliary member 940 may be disposed inside the mold member 930.

In an embodiment, the auxiliary member 940 may include a metal having a predetermined thickness. For example, the auxiliary member 940 may include a metal identical to that of a first member (e.g., the first member 410 in FIG. 6) or the second member 920. However, the disclosure is not limited thereto.

According to various embodiments, after the auxiliary member 940 is disposed inside the mold member 930 (after the mold member 930 is injected), a tapping process may be performed. In an embodiment, a fastening hole 945 may be formed to pass through at least a portion of the mold member 930 and the auxiliary member 940.

According to various embodiments, a portion of an upper area (the -z-axis direction) of the auxiliary member 940 may be exposed to the outside of the mold member 930. However, this is merely an example, and the upper area (the -z-axis direction) of the auxiliary member 940 may be disposed inside the mold member 930 as well.

FIG. 18 is a view illustrating an arrangement relationship of a first support member and a second support member according to various embodiments.

Referring to FIG. 18, a fastening member 1060 may be inserted into and disposed in a fastening hole 1025. The description of the fastening structure 500, 600, 700, 800, and 900 may be applied in whole or in part to a fastening structure 1000 in FIG. 18.

According to various embodiments, the fastening member 1060 may connect a second support member 1050 and a first support member 1001. In an embodiment, the fastening member 1060 may be inserted into a hole 1061 formed through the second support member 1050 to be disposed to the fastening hole 1025 formed on the first support member 1001. As described above, the first support member 1001 may include a first member 1010, a second member 1020, and a mold member 1030 injected to couple the first member 1010 and the second member 1020. The second support member 1060 may include a formation entirely or partially identical to that of the second support member 360 described with reference to FIG. 4.

In an embodiment, the fastening member 1060 may correspond to a screw. In case that the fastening member 1060 is inserted into and coupled to the fastening hole 1025, the fastening member 1060 may form a screw pattern 1027 on the hemmed area 1023 around the fastening hole 1025 to be coupled thereto. For example, when the fastening member 1060 is coupled, the screw pattern 1027 corresponding to a screw thread 1067 of the fastening member 1060 may be formed on the hemmed area 1023 around the fastening hole 1025.

According to various embodiments, the fastening member 1060 may pass through an upper mold member 1031 on an upper side (the -z-axis direction) of the hemmed area 1023 and may be inserted into the hemmed area 1023. For example, in case that the upper mold member 1031 covers the hemmed area 1023, the fastening member 1060 may sequentially pass through the upper mold member 1031 and the hemmed area 1023.

In some embodiments, the fastening member 1060 may completely pass through the hemmed area 1023 in the vertical direction (the z-axis direction) to be disposed. For example, in case that the fastening member 1060 completely passes through the hemmed area 1023, a predetermined gap 1038 may be formed on a lower mold member 1033 on a lower side (the +z-axis direction) of the hemmed area 1023. However, this is merely an example, and the fastening member 1060 may only partially pass through the hemmed area 1023 in the vertical direction (the z-axis direction).

According to various embodiments, the fastening hole 1025 may be provided for coupling between various internal components of an electronic device (e.g., the electronic device 101 in FIG. 4) and the first support member 1001 in addition to the second support member 1050. For example, the first support member 1001 may be connected to a circuit board (e.g., the printed circuit board 340 in FIG. 4) and/or an antenna (e.g., the antenna module 370 in FIG. 4) through the fastening hole 1025 and the fastening member 1060. In addition to this, it will be appreciated that various design variations are possible.

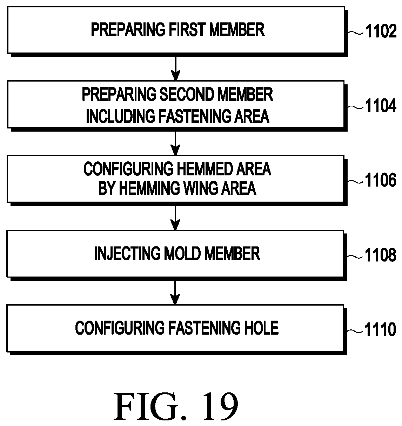

FIG. 19 is a flowchart illustrating a procedure for manufacturing a fastening structure according to various embodiments.

Referring to FIG. 19, a process of manufacturing the fastening structure (e.g., the fastening structure 500 in FIGS. 7A to 7D) may include the entirety or a portion of a process of preparing a first member (e.g., the first member 411 in FIGS. 5A to 5D) forming an outer edge of a first support member (e.g., the first support member 361 in FIG. 4) (1102), a process of preparing a second member (e.g., the second member 520 in FIGS. 7A to 7D) in which a fastening area (e.g., the fastening area 521 in FIGS. 7A to 7D) is provided (1104), a process of hemming a wing area (e.g., the wing area 522 in FIGS. 7A to 7D) to prepare a hemmed area (e.g., the hemmed area 523 in FIGS. 7A to 7D) (1106), a process of disposing the second member 520 inside the first member 510 and injecting a mold member (e.g., the mold member 530 in FIGS. 7A to 7D) (1108), and a process of processing the mold member 530 and/or the hemmed area 523 to form a fastening hole (e.g., the fastening hole 525 in FIGS. 7A to 7D) (1110).

The manufacturing process of the fastening structure (e.g., the fastening structure 500 in FIGS. 7A to 7D) may be applied in whole or in part to that of the fastening structure 500, 600, 700, 800, 900, or 1000 according to all embodiments described above, and thus an overlapping description thereof will be omitted.

## Claims

1. An electronic device (101) comprising:
a first housing comprising a first surface and a second surface opposite the first surface;
a second housing covering at least a portion of the second surface of the first housing;
a printed circuit board (340) disposed between the first housing and the second housing; and
a display (330) disposed on the first surface of the first housing and electrically connected to the printed circuit board (340),
wherein the first housing comprises:
a first member (410, 411, 510, 1010) forming an outer edge of the first housing;
a second member (420, 520, 620, 720, 820, 920, 1020) disposed inside the outer edge formed by the first member and configured to provide the second surface of the first housing to allow the printed circuit board (340) to be disposed thereon;
a mold member (430, 530, 630, 730, 830, 930, 1030) configured to couple the first member (410, 411, 510, 1010) and the second member (420, 520, 620, 720, 820, 920, 1020) and having at least a portion thereof overlapping the first member (410, 411, 510, 1010) and the second member (420, 520, 620, 720, 820, 920, 1020); and
a fastening hole (425, 525, 625, 725, 825, 945, 1025) formed to be connected to the second housing through a fastening member (900, 1060),
wherein the second member comprises:
a fastening area (422, 521, 522, 621) which is disposed inside the mold member (430, 530, 630, 730, 830, 930, 1030) and formed by hemming at least a portion of the fastening area (422, 521, 522, 621) to extend in a direction that the second surface faces, and
wherein the fastening hole (425, 525, 625, 725, 825, 945, 1025) is formed through at least a portion of the fastening area (422, 521, 522, 621) of the second member (420, 520, 620, 720, 820, 920, 1020) disposed inside the mold member (430, 530, 630, 730, 830, 930, 1030).

2. The electronic (101) device of claim 1, wherein the fastening area (422, 521, 522, 621) is formed by hemming at least a portion of two or more wing areas (522a-c) extending in directions perpendicular to each other so as to overlap each other.

3. The electronic device (101) of claim 1, wherein the fastening area (422, 521, 522, 621) is formed by hemming one wing area (522a-c) multiple times.

4. The electronic device (101) of claim 1, wherein the fastening area (422, 521, 522, 621) comprises a first hemmed area (723a, 823a) formed by hemming a first wing area (522a) extending to face a first direction and a second hemmed area (723b, 823b) formed by hemming a second wing area (522b) extending to face a second direction opposite the first direction.

5. The electronic device (101) of claim 4, wherein a width of the first hemmed area (723a, 823a) is greater than that of the second hemmed area (723b, 823b).

6. The electronic device (101) of claim 4, wherein the fastening hole (425, 525, 625, 725, 825, 945, 1025) is formed through at least a portion of the first hemmed area (723a, 823a).

7. The electronic device (101) of claim 5, wherein the mold member (430, 530, 630, 730, 830, 930, 1030) is formed to surround the second hemmed area (723b, 823b) to improve the rigidity of a portion, around the fastening hole (425, 525, 625, 725, 825, 945, 1025), of the housing.

8. The electronic device (101) of claim 1, wherein the fastening area (422, 521, 522, 621) is formed by hemming at least a portion of the second member (420, 520, 620, 720, 820, 920, 1020) to face a direction perpendicular to a surface of the second member (420, 520, 620, 720, 820, 920, 1020).

9. The electronic device (101) of claim 1, further comprising a second fastening hole formed through another portion of the second member (420, 520, 620, 720, 820, 920, 1020) and another portion of the mold member (430, 530, 630, 730, 830, 930, 1030),
wherein the second fastening hole is coupled to the printed circuit board (340) through a fastening member (900, 1060).

10. The electronic device (101) of claim 1, wherein at least a portion of an upper surface of the fastening area (422, 521, 522, 621) is exposed to the outside of the mold member (430, 530, 630, 730, 830, 930, 1030).

11. The electronic device (101) of claim 10, wherein the upper surface of the fastening area (422, 521, 522, 621) exposed to the outside of the mold member (430, 530, 630, 730, 830, 930, 1030) is provided as a ground.

12. A method for manufacturing a housing of the electronic device (101) according to any of claims 1 to 11, the method comprising:
forming a first member (410, 411, 510, 1010) configured to be exposed to the outside of the electronic device (101) and disposed along an edge of the electronic device (101);
disposing a second member (420, 520, 620, 720, 820, 920, 1020) inside the first member (410, 411, 510, 1010);
forming a fastening area (422, 521, 522, 621) on the second member (420, 520, 620, 720, 820, 920, 1020), wherein the second member (420, 520, 620, 720, 820, 920, 1020) comprises a wing area (522a-c) formed by cutting at least portion of the second member (420, 520, 620, 720, 820, 920, 1020), and the fastening area (422, 521, 522, 621) extending in a direction perpendicular to a surface of the second member (420, 520, 620, 720, 820, 920, 1020) is formed by hemming at least a portion of the wing area (522a-c);
injecting a mold member (430, 530, 630, 730, 830, 930, 1030) to couple the first member (410, 411, 510, 1010) and the second member (420, 520, 620, 720, 820, 920, 1020), wherein the mold member (430, 530, 630, 730, 830, 930, 1030) is injected to allow the fastening area (422, 521, 522, 621) to be disposed inside the mold member (430, 530, 630, 730, 830, 930, 1030); and
forming a fastening hole (425, 525, 625, 725, 825, 945, 1025) to pass through at least a portion of the fastening area (422, 521, 522, 621).

13. The method of claim 12, wherein the wing area (522a-c) comprises a first wing area (522a) and a second wing area (522b) extending in directions perpendicular to each other, and
wherein the fastening area (422, 521, 522, 621) is formed by hemming at least a portion of the first wing area (522a) and at least a portion of the second wing area (522b) to overlap each other.

14. The method of claim 12, wherein the forming of the fastening area (422, 521, 522, 621) further comprises:
forming a first folded area (723a, 823a) by folding the first wing area (522a) extending to face a first direction; and
forming a second hemmed area (723b, 823b) by folding the second wing area (522b) extending to face a second direction opposite to the first direction and disposed adjacent to the first wing area (522a), and
wherein the second hemmed area (723b, 823b) is disposed inside the mold member (430, 530, 630, 730, 830, 930, 1030).

15. The method of claim 12, further comprising processing at least a portion of the mold member (430, 530, 630, 730, 830, 930, 1030) to cause an upper end area of the fastening area (422, 521, 522, 621) to be exposed to the outside of the mold member (430, 530, 630, 730, 830, 930, 1030),
wherein the upper end area of the fastening area (422, 521, 522, 621) exposed to the outside of the mold member (430, 530, 630, 730, 830, 930, 1030) is provided as a ground.

## Patentansprüche

1. Elektronische Vorrichtung (101), umfassend:
ein erstes Gehäuse, das eine erste Oberfläche und eine zweite Oberfläche gegenüber der ersten Oberfläche umfasst;
ein zweites Gehäuse, das mindestens einen Abschnitt der zweiten Oberfläche des ersten Gehäuses abdeckt;
eine Leiterplatte (340), die zwischen dem ersten Gehäuse und dem zweiten Gehäuse angeordnet ist; und
eine Anzeige (330), die auf der ersten Oberfläche des ersten Gehäuses angeordnet ist und elektrisch mit der Leiterplatte (340) verbunden ist,
wobei das erste Gehäuse Folgendes umfasst:
ein erstes Element (410, 411, 510, 1010), das eine Außenkante des ersten Gehäuses bildet;
ein zweites Element (420, 520, 620, 720, 820, 920, 1020), das innerhalb der Außenkante, die durch das erste Element gebildet wird, angeordnet ist und dazu konfiguriert ist, die zweite Oberfläche des ersten Gehäuses bereitzustellen, um zu ermöglichen, dass die Leiterplatte (340) darauf angeordnet wird;
ein Formelement (430, 530, 630, 730, 830, 930, 1030), das dazu konfiguriert ist, das erste Element (410, 411, 510, 1010) und das zweite Element (420, 520, 620, 720, 820, 920, 1020) zu koppeln, und mindestens einen Abschnitt davon aufweist, der das erste Element (410, 411, 510, 1010) und das zweite Element (420, 520, 620, 720, 820, 920, 1020) überlappt; und
ein Befestigungsloch (425, 525, 625, 725, 825, 945, 1025), das dazu ausgebildet ist, durch ein Befestigungselement (900, 1060) mit dem zweiten Gehäuse verbunden zu werden, wobei das zweite Element Folgendes umfasst:
einen Befestigungsbereich (422, 521, 522, 621), der innerhalb des Formelements (430, 530, 630, 730, 830, 930, 1030) angeordnet ist und durch Bördeln zumindest eines Abschnitts des Befestigungsbereichs (422, 521, 522, 621) gebildet wird, um sich in eine Richtung zu erstrecken, in die die zweite Oberfläche zeigt, und
wobei das Befestigungsloch (425, 525, 625, 725, 825, 945, 1025) durch zumindest einen Abschnitt des Befestigungsbereichs (422, 521, 522, 621) des zweiten Elements (420, 520, 620, 720, 820, 920, 1020), der innerhalb des Formelements (430, 530, 630, 730, 830, 930, 1030) angeordnet ist, ausgebildet ist.

2. Elektronische (101) Vorrichtung nach Anspruch 1, wobei der Befestigungsbereich (422, 521, 522, 621) durch Bördeln zumindest eines Abschnitts von zwei oder mehr Flügelbereichen (522a-c) gebildet wird, die sich in Richtungen senkrecht zueinander erstrecken, um einander zu überlappen.

3. Elektronische Vorrichtung (101) nach Anspruch 1, wobei der Befestigungsbereich (422, 521, 522, 621) durch mehrfaches Bördeln eines Flügelbereichs (522a-c) gebildet wird.

4. Elektronische Vorrichtung (101) nach Anspruch 1, wobei der Befestigungsbereich (422, 521, 522, 621) einen ersten gebördelten Bereich (723a, 823a), der durch Bördeln eines ersten Flügelbereichs (522a) gebildet wird, der sich erstreckt, um in eine erste Richtung zu zeigen, und einen zweiten gebördelten Bereich (723b, 823b), der durch Bördeln eines zweiten Flügelbereichs (522b) gebildet wird, der sich erstreckt, um in eine zweite Richtung entgegengesetzt zu der ersten Richtung zu zeigen, umfasst.

5. Elektronische Vorrichtung (101) nach Anspruch 4, wobei eine Breite des ersten gebördelten Bereichs (723a, 823a) größer als diejenige des zweiten gebördelten Bereichs (723b, 823b) ist.

6. Elektronische Vorrichtung (101) nach Anspruch 4, wobei das Befestigungsloch (425, 525, 625, 725, 825, 945, 1025) durch zumindest einen Abschnitt des ersten gebördelten Bereichs (723a, 823a) ausgebildet ist.

7. Elektronische Vorrichtung (101) nach Anspruch 5, wobei das Formelement (430, 530, 630, 730, 830, 930, 1030) ausgebildet ist, um den zweiten gebördelten Bereich (723b, 823b) zu umgeben, um die Steifigkeit eines Abschnitts um das Befestigungsloch (425, 525, 625, 725, 825, 945, 1025) des Gehäuses zu verbessern.

8. Elektronische Vorrichtung (101) nach Anspruch 1, wobei der Befestigungsbereich (422, 521, 522, 621) durch Bördeln zumindest eines Abschnitts des zweiten Elements (420, 520, 620, 720, 820, 920, 1020), um in eine Richtung senkrecht zu einer Oberfläche des zweiten Elements (420, 520, 620, 720, 820, 920, 1020) zu zeigen, gebildet wird.

9. Elektronische Vorrichtung (101) nach Anspruch 1, ferner umfassend ein zweites Befestigungsloch, das durch einen anderen Abschnitt des zweiten Elements (420, 520, 620, 720, 820, 920, 1020) und einen anderen Abschnitt des Formelements (430, 530, 630, 730, 830, 930, 1030) ausgebildet ist, wobei das zweite Befestigungsloch durch ein Befestigungselement (900, 1060) an die Leiterplatte (340) gekoppelt ist.

10. Elektronische Vorrichtung (101) nach Anspruch 1, wobei zumindest ein Abschnitt einer oberen Oberfläche des Befestigungsbereichs (422, 521, 522, 621) zu der Außenseite des Formelements (430, 530, 630, 730, 830, 930, 1030) freigelegt ist.

11. Elektronische Vorrichtung (101) nach Anspruch 10, wobei die obere Oberfläche des Befestigungsbereichs (422, 521, 522, 621), die zu der Außenseite des Formelements (430, 530, 630, 730, 830, 930, 1030) freigelegt ist, als Masse bereitgestellt ist.

12. Verfahren zur Herstellung eines Gehäuses der elektronischen Vorrichtung (101) nach einem der Ansprüche 1 bis 11, wobei das Verfahren Folgendes umfasst:
Bilden eines ersten Elements (410, 411, 510, 1010), das dazu konfiguriert ist, zu der Außenseite der elektronischen Vorrichtung (101) freigelegt zu sein und entlang einer Kante der elektronischen Vorrichtung (101) angeordnet zu sein;
Anordnen eines zweiten Elements (420, 520, 620, 720, 820, 920, 1020) innerhalb des ersten Elements (410, 411, 510, 1010);
Bilden eines Befestigungsbereichs (422, 521, 522, 621) an dem zweiten Element (420, 520, 620, 720, 820, 920, 1020), wobei das zweite Element (420, 520, 620, 720, 820, 920, 1020) einen Flügelbereich (522a-c) umfasst, der durch Schneiden zumindest eines Abschnitts des zweiten Elements (420, 520, 620, 720, 820, 920, 1020) gebildet wird, und der Befestigungsbereich (422, 521, 522, 621), der sich in einer Richtung senkrecht zu einer Oberfläche des zweiten Elements (420, 520, 620, 720, 820, 920, 1020) erstreckt, durch Bördeln zumindest eines Abschnitts des Flügelbereichs (522a-c) gebildet wird;
Spritzen eines Formelements (430, 530, 630, 730, 830, 930, 1030), um das erste Element (410, 411, 510, 1010) und das zweite Element (420, 520, 620, 720, 820, 920, 1020) zu koppeln, wobei das Formelement (430, 530, 630, 730, 830, 930, 1030) gespritzt wird, um zu ermöglichen, dass der Befestigungsbereich (422, 521, 522, 621) innerhalb des Formelements (430, 530, 630, 730, 830, 930, 1030) angeordnet wird; und
Ausbilden eines Befestigungslochs (425, 525, 625, 725, 825, 945, 1025), um durch zumindest einen Abschnitt des Befestigungsbereichs (422, 521, 522, 621) zu verlaufen.

13. Verfahren nach Anspruch 12, wobei der Flügelbereich (522a-c) einen ersten Flügelbereich (522a) und einen zweiten Flügelbereich (522b) umfasst, die sich in Richtungen senkrecht zueinander erstrecken, und
wobei der Befestigungsbereich (422, 521, 522, 621) durch Bördeln zumindest eines Abschnitts des ersten Flügelbereichs (522a) und zumindest eines Abschnitts des zweiten Flügelbereichs (522b) gebildet wird, um einander zu überlappen.

14. Verfahren nach Anspruch 12, wobei das Bilden des Befestigungsbereichs (422, 521, 522, 621) ferner Folgendes umfasst:
Bilden eines ersten gefalteten Bereichs (723a, 823a) durch Falten des ersten Flügelbereichs (522a), der sich erstreckt, um in eine erste Richtung zu zeigen; und
Bilden eines zweiten gebördelten Bereichs (723b, 823b) durch Falten des zweiten Flügelbereichs (522b), der sich erstreckt, um in eine zweite Richtung entgegengesetzt zu der ersten Richtung zu zeigen, und benachbart zu dem ersten Flügelbereich (522a) angeordnet ist, und
wobei der zweite gebördelte Bereich (723b, 823b) innerhalb des Formelements (430, 530, 630, 730, 830, 930, 1030) angeordnet ist.

15. Verfahren nach Anspruch 12, ferner umfassend das Verarbeiten zumindest eines Abschnitts des Formelements (430, 530, 630, 730, 830, 930, 1030), um zu bewirken, dass ein oberer Endbereich des Befestigungsbereichs (422, 521, 522, 621) zu der Außenseite des Formelements (430, 530, 630, 730, 830, 930, 1030) freigelegt wird, wobei der obere Endbereich des Befestigungsbereichs (422, 521, 522, 621), der zu der Außenseite des Formelements (430, 530, 630, 730, 830, 930, 1030) freigelegt wird, als Masse bereitgestellt wird.

## Revendications

1. Dispositif électronique (101) comprenant :
un premier boîtier comprenant une première surface et une seconde surface opposée à la première surface ;
un second boîtier couvrant au moins une partie de la seconde surface du premier boîtier ;
une carte de circuit imprimé (340) disposée entre le premier boîtier et le second boîtier ; et
un afficheur (330) disposé sur la première surface du premier boîtier et raccordé électriquement à la carte de circuit imprimé (340),
ledit premier boîtier comprenant :
un premier élément (410, 411, 510, 1010) formant un bord externe du premier boîtier ;
un second élément (420, 520, 620, 720, 820, 920, 1020) disposé à l'intérieur du bord externe formé par le premier élément et conçu pour fournir la seconde surface du premier boîtier pour permettre à la carte de circuit imprimé (340) d'être disposée sur celui-ci ;
un élément de moule (430, 530, 630, 730, 830, 930, 1030) conçu pour coupler le premier élément (410, 411, 510, 1010) et le second élément (420, 520, 620, 720, 820, 920, 1020) et possédant au moins une partie de celui-ci chevauchant le premier élément (410, 411, 510, 1010) et le second élément (420, 520, 620, 720, 820, 920, 1020) ; et
un trou de fixation (425, 525, 625, 725, 825, 945, 1025) formé pour être raccordé au second boîtier par l'intermédiaire d'un élément de fixation (900, 1060), ledit second élément comprenant :
une zone de fixation (422, 521, 522, 621) qui est disposée à l'intérieur de l'élément de moule (430, 530, 630, 730, 830, 930, 1030) et formée en rabattant au moins une partie de la zone de fixation (422, 521, 522, 621) pour s'étendre dans une direction à laquelle la seconde surface fait face, et
ledit trou de fixation (425, 525, 625, 725, 825, 945, 1025) étant formé à travers au moins une partie de la zone de fixation (422, 521, 522, 621) du second élément (420, 520, 620, 720, 820, 920, 1020) disposée à l'intérieur de l'élément de moule (430, 530, 630, 730, 830, 930, 1030).

2. Dispositif électronique (101) de la revendication 1, ladite zone de fixation (422, 521, 522, 621) étant formée en rabattant au moins une partie de deux, ou plus, zones d'aile (522a-c) s'étendant dans des directions perpendiculaires l'une à l'autre de façon à se chevaucher l'une l'autre.

3. Dispositif électronique (101) de la revendication 1, ladite zone de fixation (422, 521, 522, 621) étant formée en rabattant une zone d'aile (522a-c) plusieurs fois.

4. Dispositif électronique (101) de la revendication 1, ladite zone de fixation (422, 521, 522, 621) comprenant une première zone rabattue (723a, 823a) formée en rabattant une première zone d'aile (522a) s'étendant pour faire face à une première direction et une seconde zone rabattue (723b, 823b) formée en rabattant une seconde zone d'aile (522b) s'étendant pour faire face à une seconde direction opposée à la première direction.

5. Dispositif électronique (101) de la revendication 4, une largeur de la première zone rabattue (723a, 823a) étant supérieure à celle de la seconde zone rabattue (723b, 823b).

6. Dispositif électronique (101) de la revendication 4, ledit trou de fixation (425, 525, 625, 725, 825, 945, 1025) étant formé à travers au moins une partie de la première zone rabattue (723a, 823a).

7. Dispositif électronique (101) de la revendication 5, ledit élément de moule (430, 530, 630, 730, 830, 930, 1030) étant formé pour entourer la seconde zone rabattue (723b, 823b) pour améliorer la rigidité d'une partie, autour du trou de fixation (425, 525, 625, 725, 825, 945, 1025), du boîtier.

8. Dispositif électronique (101) de la revendication 1, ladite zone de fixation (422, 521, 522, 621) étant formée en rabattant au moins une partie du second élément (420, 520, 620, 720, 820, 920, 1020) pour faire face à une direction perpendiculaire à une surface du second élément (420, 520, 620, 720, 820, 920, 1020).

9. Dispositif électronique (101) de la revendication 1, comprenant en outre un second trou de fixation formé à travers une autre partie du second élément (420, 520, 620, 720, 820, 920, 1020) et une autre partie de l'élément de moule (430, 530, 630, 730, 830, 930, 1030), ledit second trou de fixation étant couplé à la carte de circuit imprimé (340) par l'intermédiaire d'un élément de fixation (900, 1060).

10. Dispositif électronique (101) de la revendication 1, au moins une partie d'une surface supérieure de la zone de fixation (422, 521, 522, 621) étant exposée à l'extérieur de l'élément de moule (430, 530, 630, 730, 830, 930, 1030).

11. Dispositif électronique (101) de la revendication 10, ladite surface supérieure de la zone de fixation (422, 521, 522, 621) exposée à l'extérieur de l'élément de moule (430, 530, 630, 730, 830, 930, 1030) étant fournie en tant que masse.

12. Procédé permettant la fabrication d'un boîtier du dispositif électronique (101) selon l'une quelconque des revendications 1 à 11, le procédé comprenant :
la formation d'un premier élément (410, 411, 510, 1010) conçu pour être exposé à l'extérieur du dispositif électronique (101) et disposé le long d'un bord du dispositif électronique (101) ;
la disposition d'un second élément (420, 520, 620, 720, 820, 920, 1020) à l'intérieur du premier élément (410, 411, 510, 1010) ;
la formation d'une zone de fixation (422, 521, 522, 621) sur le second élément (420, 520, 620, 720, 820, 920, 1020), ledit second élément (420, 520, 620, 720, 820, 920, 1020) comprenant une zone d'aile (522a-c) formée en coupant au moins une partie du second élément (420, 520, 620, 720, 820, 920, 1020), et ladite zone de fixation (422, 521, 522, 621) s'étendant dans une direction perpendiculaire à une surface du second élément (420, 520, 620, 720, 820, 920, 1020) étant formée en rabattant au moins une partie de la zone d'aile (522a-c) ;
l'injection d'un élément de moule (430, 530, 630, 730, 830, 930, 1030) pour coupler le premier élément (410, 411, 510, 1010) et le second élément (420, 520, 620, 720, 820, 920, 1020), ledit élément de moule (430, 530, 630, 730, 830, 930, 1030) étant injecté pour permettre à la zone de fixation (422, 521, 522, 621) d'être disposée à l'intérieur de l'élément de moule (430, 530, 630, 730, 830, 930, 1030) ; et
la formation d'un trou de fixation (425, 525, 625, 725, 825, 945, 1025) pour passer à travers au moins une partie de la zone de fixation (422, 521, 522, 621).

13. Procédé de la revendication 12, ladite zone d'aile (522a-c) comprenant une première zone d'aile (522a) et une seconde zone d'aile (522b) s'étendant dans des directions perpendiculaires l'une à l'autre, et
ladite zone de fixation (422, 521, 522, 621) étant formée en rabattant au moins une partie de la première zone d'aile (522a) et au moins une partie de la seconde zone d'aile (522b) pour se chevaucher l'une l'autre.

14. Procédé de la revendication 12, ladite formation de la zone de fixation (422, 521, 522, 621) comprenant en outre :
la formation d'une première zone pliée (723a, 823a) en pliant la première zone d'aile (522a) s'étendant pour faire face à une première direction ; et
la formation d'une seconde zone rabattue (723b, 823b) en pliant la seconde zone d'aile (522b) s'étendant pour faire face à une seconde direction opposée à la première direction et disposée adjacente à la première zone d'aile (522a), et
ladite seconde zone rabattue (723b, 823b) étant disposée à l'intérieur de l'élément de moule (430, 530, 630, 730, 830, 930, 1030).

15. Procédé de la revendication 12, comprenant en outre le traitement d'au moins une partie de l'élément de moule (430, 530, 630, 730, 830, 930, 1030) pour amener une zone d'extrémité supérieure de la zone de fixation (422, 521, 522, 621) à être exposée à l'extérieur de l'élément de moule (430, 530, 630, 730, 830, 930, 1030),
ladite zone d'extrémité supérieure de la zone de fixation (422, 521, 522, 621) exposée à l'extérieur de l'élément de moule (430, 530, 630, 730, 830, 930, 1030) étant fournie en tant que masse.
